# EUROPEAN PATENT SPECIFICATION

(11) **EP 0 579 473 B1**
(45) Date of publication and mention of the grant of the patent: **04.11.1998**
(21) Application number: 93305462.9
(22) Date of filing: 13.07.1993
(51) Int. Cl.: G01R 33/36

(54) **Tunable RF probe for use in NMR spectroscopy experiments and method of tuning**
Abstimmbare Hochfrequenz-Sonde für magnetische Kernresonanz-Spektroskopie-Untersuchungen und Abstimmungsverfahren
Sonde RF accordable utilisée dans des expériences de spectroscopie RMN et procédé d'accordage

(30) Priority: 14.07.1992 US 913568
(43) Date of publication of application: 19.01.1994
(73) Proprietor: VARIAN ASSOCIATES, INC., Palo Alto, California 94304 (US)
(72) Inventor: Palmer, Allen R., Bellvue, Colorado 80512 (US)
(74) Representative: Jones, Alan John

(56) References cited:
- US-A- 4 833 412
- US-A- 5 036 426
- US-A- 5 055 792
- MAGNETIC RESONANCE IN MEDICINE. vol. 13, no. 3, 1 March 1990, DULUTH,MN US pages 370 - 377 A.R. RATH 'EFFICIENT REMOTE TRANSMISSION LINE PROBE TUNING'
- MAGNETIC RESONANCE IN MEDICINE. vol. 3, no. 2, 1 April 1986, DULUTH,MN US pages 346 - 351 J.F. MARTIN ET AL. 'TRANSMISSION LINE MATCHING OF SURFACE COILS'
- MAGNETIC RESONANCE IN MEDICINE. vol. 13, no. 3, 1 March 1990, DULUTH,MN US pages 378 - 384 R. DUENSING ET AL. 'A CONTINUOUSLY VARIABLE FIELD OF VIEW SURFACE COIL'

## Description

### BACKGROUND OF THE INVENTION

The present invention relates generally to single-, double-, triple-, or quadruple-tuned Nuclear Magnetic Resonance (NMR) probes. And more particularly, this invention relates to single radio-frequency (RF) coil NMR probes, which are tunable by changing the geometry of a single-port tunable element, for use in single-, double-, triple-, or quadruple-resonance spectroscopy experiments.

Samples studied using NMR spectroscopy equipment can be irradiated with up to four RF signals (each having a different frequency) generated by, typically, one or more RF coils. A "single-coil" NMR probe uses one RF coil capable of generating the desired RF signal(s) as well as receiving/detecting resultant signals radiated from a sample. In operation, the RF coil of a single-coil NMR probe transmits RF energy at the desired frequency(ies) to excite nuclear spins (a nuclear spin is the total angular momentum of an atomic nucleus) in a sample. When an RF excitation ceases, the excited nuclei of the sample radiate energy that is detected by the RF coil. Most NMR systems irradiate samples with RF energy at multiple frequencies. For example, double-resonance NMR experiments performed on solid samples utilize NMR probes capable of transmitting RF signals at two frequencies: a low RF frequency and a high RF frequency. Probes used in double-resonance NMR experiments are commonly referred to as "double-tuned" since the high-frequency and the low-frequency resonant circuits must both be tuned. Likewise, triple-resonance NMR experiments utilize "triple-tuned" NMR probes capable of transmitting RF signals at three frequencies: a low, middle, and high RF frequency. Probes used in triple-resonance NMR-experiments are commonly referred to as "triple-tuned". Although not as commonly used today, one can use separate RF coils for transmitting and receiving rather than a single RF coil capable of doing both.

One known NMR probe for use in double-resonance NMR experiments uses two separate orthogonal coils for transmitting RF signals--one coil is capable of transmitting the high-frequency RF signal and the other capable of transmitting the low-frequency RF signal. An advantage of these dual-coil probes is that the low- and high-frequency circuits are physically isolated. One problem with these dual-coil probes is that they promote inhomogeneities in the two RF frequency fields produced. RF field inhomogeneities lead to a degradation of the quality of experimental results. Another problem with the dual-coil probes is that they have an inner and an outer coil. The outer coil operates less efficiently since it has greater spatial separation from the sample. Additionally, a problem of arcing between the two coils usually limits this type of known probe to low power experiments.

A typical double-resonance experiment involves irradiating a sample with a high-frequency RF signal while a lower frequency radiation from the sample is observed. For experiments using solid-state samples, the high-frequency power level is generally 70-600 watts whereas the low frequency radiation from the sample may be less than a nanowatt. Regardless of the number of RF signal transmit coils used in an NMR probe, it is desirable to isolate the high-frequency circuit from the low-frequency circuit in double-tuned NMR probes. Similarly, it is desirable to isolate all three frequencies from each other in a triple-tuned NMR probe.

One type of conventional single-coil double-resonance NMR probe is discussed in an article titled "Single-coil Probe With Transmission-Line Tuning for Nuclear Magnetic Double Resonance" written by V.R. Cross, R. K. Hester, and J. S. Waugh. The article appears in the Review of Scientific Instrumentation, Vol. 47, No. 12, December 1976. The Cross probe uses variable length transmission lines to tune the circuits. The tuning range of the high-frequency (HF) circuit is limited since most of the voltage in the high-frequency circuit is across this fixed capacitor. Also, if only a moderate voltage drop is placed across the fixed capacitor, then the variable transmission line will have the effect of increasing the voltage across the variable capacitor. In addition to the variable-length transmission lines, an open transmission-line segment and a shorted transmission-line segment are still required for frequency isolation. The losses in these transmission lines make the Cross probe impractical for use with today's high-frequency spectrometers.

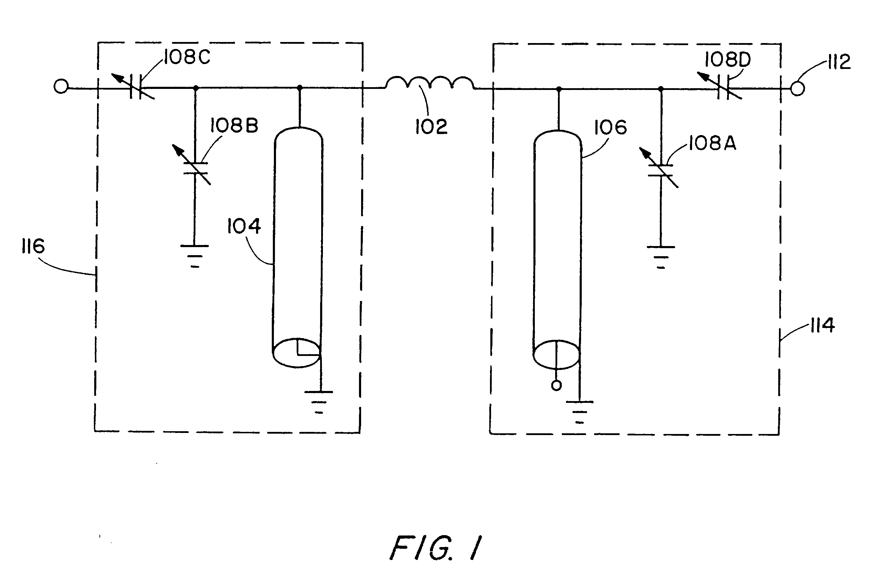

Turning to the known probe at 100 in Figure 1, variable tuning capacitors 108A, 108B replace the variable length transmission lines of the Cross probe. Furthermore, no fixed capacitor has been included in probe 100. RF sample coil 102 is used to generate the dual-frequency radiation and detect the radiation from the excited sample nuclei. Shorted transmission line segment 104 (its center conductor has been grounded) has a high input impedance at the high frequency, but passes the low frequencies to ground to isolate the low-frequency power from the high-frequency side 116 of the probe 100. Open transmission line segment 106 passes the high-frequency to ground to isolate the high frequency from the low-frequency side 114 of the probe 100.

One disadvantage of the single-coil double-resonance NMR probe 100 is that it requires four high voltage, high current variable capacitors 108A, 108B, 108C, 108D. Not only do these capacitors consume space, but the operating power level of the probe 100 is limited as a result of including these capacitors. Other disadvantages of probe 100 include: the finite impedance presented by the shorted transmission line segment 104 results in a dramatic loss in high-frequency efficiency; and the low-frequency side 114 is difficult to tune at the frequencies on the high end of the low-frequency range.

In "A Multinuclear Double-Tuned Probe for Applications with Solids or Liquids Utilizing Lumped Tuning Elements" by F. David Doty, Ruth R. Inners, and Paul D. Ellis, appearing in the Journal of Magnetic Resonance 43, pp. 399-416 (1981), another single-coil double-resonance NMR probe is disclosed. The Doty probe uses lumped element equivalents (combinations of capacitors and inductors) in place of the transmission line segments 104, 106 of probe 100 in Figure 1. A primary disadvantage of this design is that the variable inductor used in the high-voltage region of the probe (see pages 412-413 of the Doty article) introduces significant low-frequency losses and limits the range of high-frequency applications.

US -A-4,446,431 issued to Robert A. McKay describes yet another single-coil double-resonance NMR probe. The McKay probe uses a tapped transmission line having. two segments and a Junction Point B where the low frequency input and detection circuit connects to the transmission line. Disadvantages of the McKay probe are as follows: the length of the tapped transmission line results in losses at both frequencies (which is a problem, in particular, for probes operating at a high-frequency above 300MHz); the probe does not isolate the low-frequency energy from the high-frequency circuit; both the high-frequency and low-frequency portions of the probe are at high voltage on the same side of the sample coil which increases the possibility of arcing; and, each time a different high-frequency is chosen, Junction Point B must be changed which limits the high-frequency tuning range of the McKay probe.

Another use of the variable length transmission line in an NMR probe is described in US-A-5055792. This Patent discloses the use of a two-port two wire transmission line segment to replace variable inductors in a multi-frequency circuit in which a cascade of tank circuits is used to combine several frequencies to operate from a single RF port.

In accordance with a first aspect of the present invention, there is provided an NMR probe for transmitting RF energy between a source and a sample coil, as defined by Claim 1.

In accordance with a second aspect of the present invention, there is provided a method for tuning and matching an RF resonant circuit of an NMR RF probe, as defined by Claim 17.

### BRIEF DESCRIPTION OF THE DRAWINGS

The present invention will be described with reference to the accompanying drawings, wherein:

Fig. 1 is a schematic illustrating a known single-coil double-tuned NMR probe 100 using transmission line segments 104, 106 for frequency isolation and capacitors for circuit tuning.

Fig. 2 is a schematic of a single-coil double-tuned NMR probe 500 of the present invention.

Fig. 3 is a schematic of a single-coil triple-resonance NMR probe 600 of the present invention.

Fig. 4 is an exploded-assembly illustrating one set of preferred mechanical components which can be assembled to form a single-port tunable element such as that shown in Figure 2.

Fig. 5 is a schematic incorporating certain mechanical features of the Fig. 4 tunable element with the electrical schematic of Fig. 2.

### DETAILED DESCRIPTION OF THE PREFERRED EMBODIMENTS

To perform NMR spectroscopy, an NMR probe is used to generate and detect RF signals which are processed by the spectrometer to produce a spectrum. The tunable element NMR probe of the present invention can be used with most existing standard NMR spectrometers without any modifications to the spectrometers. An example of a spectrometer to which this probe may be interfaced is the CMX-II Spectrometer available from Chemagnetics in Fort Collins, Colorado.

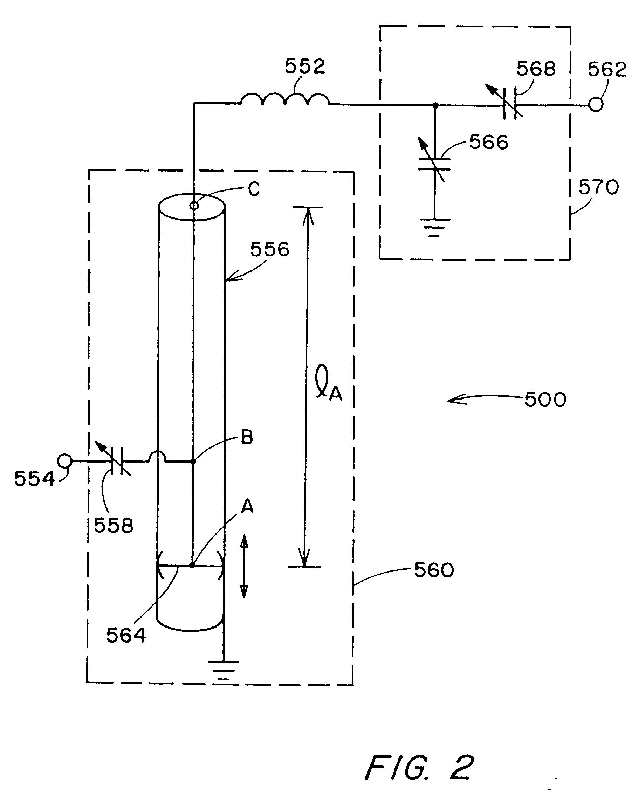

Figure 2 illustrates a single-port tunable element NMR probe 500 for use in double-resonance spectroscopy experiments. The tunable element NMR probe 500 includes off-the-shelf components as well as a custom fabricated single-port tunable element 556. Sample coil 552 is used to irradiate a sample (not shown, but is positioned within the windings of the sample coil) to be analyzed with high- and low-frequency RF energy. Sample coils are typically made out of silver-plated copper wire into a helix. High-frequency RF energy is input to the probe via high-frequency terminal 554 from a spectrometer (not shown). Low-frequency RF energy is input to the probe from the spectrometer at a low-frequency terminal 562. These inputs are located at either end of sample coil 552. The sample coil 552 irradiates the sample being analyzed with these RF frequencies. The sample coil 552 also receives low- and high-frequency RF radiation from the sample. This detected radiation resonates in the sample coil as well as tuned circuits 560, 570 of the NMR probe 500 (discussed in greater detail below). Low-frequency detected radiation is sent to the spectrometer through low-frequency terminal 562. High-frequency detected radiation is sent to the spectrometer through the high-frequency terminal 554.

Low-frequency RF energy detected by the sample coil resonates in the sample coil 552 and the low-frequency resonant circuit 570 of the probe. As illustrated, the low-frequency resonant circuit 570 comprises a tuning capacitor 566, for tuning circuit 570, and a matching capacitor 568. The tuning capacitor 566 also isolates the high-frequencies from the low-frequency portion of the probe 500 by shorting the high frequencies to ground through variable capacitor 566. The low-frequency circuit 570 must be impedance matched, using suitable means such as a matching capacitor 568, to the impedance of the spectrometer channel (not shown) used and the impedance of the preamplifier used (not shown).

High frequencies transmitted to, or detected from, the sample by the sample coil 552 resonate in the sample coil 552 and high-frequency circuit 560. The unique design of high-frequency resonant circuit 560 includes a tunable element 556 and a matching capacitor 558 located between high-frequency terminal 554 and the inner conductor of tunable element 556 at point B. The physical location of the electrical connecting point of matching capacitor 558 and the inner conductor of tunable element 556 is not critical. Not only is the tunable element 556 used to tune the high-frequency resonant circuit 560, but it operates to isolate the low-frequency energy from high-frequency circuit 560 and it allows for positioning of high-frequency matching capacitor 558 away from the high voltage region (near point C) of the probe.

Tuning of the high-frequency resonant circuit 560 at a desired frequency is accomplished by changing the conductor length ℓ_{A} of the tunable element. This changes the impedance seen by the sample coil 552. Changing the length of the tunable element 556 illustrated in Figure 2 is accomplished by sliding a contact strip 564 along a portion of the length of the tunable element 556. The contact strip 564 shorts the inner conductor of the tunable element 556 to its grounded housing (not labeled) at a point A. The tunable element 556 is tuned so that, at grounded point A, the high-frequency voltage level is zero and the high-frequency current is high.

As already mentioned briefly, tunable element 556 can isolate the low-frequencies from the high-frequency terminal 554 to minimize interference with the high-frequency signals sent to the spectrometer. The low-frequency voltage is grounded at point A via the inner conductor and contact strip 564. Since the length of the tunable element 556 is short compared to the wavelength of the low frequencies, the low-frequency voltage is fairly constant along the entire length of the tunable element 556. Therefore, the low-frequency voltage is no more than a few volts at point B, where it would most interfere with the high-frequency signal if the voltage was high. Furthermore, the reactance of high-frequency matching capacitor 558 is high for the low-frequencies used.

The design of present invention allows one to position matching capacitor 558 in a low-voltage region of the probe 500. Grounded point A is the point where the high-frequency voltage is minimum; zero for a properly tuned circuit. A point C near the coil 552 is the point at which the high-frequency voltage is maximum. The matching capacitor 558 is electrically connected to the inner conductor at point B. The closer point B is to point A, the lower the voltage at point B.

In the preferred embodiments of Figures 2-5, there is a tradeoff to moving point B closer to point A: as point B is moved closer to point A, the tuning range of the tunable element RF probe 500 is diminished. If, for example, point B is positioned at a point 52% of the distance from point A to point C, the tuning range is 40% of the high-frequency. In Figure 2, point B is positioned at a point approximately 30% of the distance from point A to point C. This provides a tuning range of 25% of the high-frequency value chosen and positions the matching capacitor 558 at a low enough voltage level to satisfy safety concerns. A tuning range of 25% of the high-frequency is a substantial improvement over conventional single-coil double-tuned NMR probes, which typically have tuning ranges of about 2%.

Component values for the embodiment are illustrated by the following example. For a probe operating at a high-frequency of 400 Mhz and a low-frequency from 40-160 Mhz, typical component values are as follows. The high-frequency matching capacitor 558 is a 0.3-3.0 picofarads (pf) variable capacitor; the sample coil is 200 nanohenrys (nH); the low-frequency tuning capacitor is 1-80 pf; and the low-frequency matching capacitor is 1-7 pf. For operation at different frequencies, one with ordinary skill in the art can easily determine new component values. The length of the tapped tunable element 556 is chosen to be slightly longer than λ√4 where λ is the wavelength of the high-frequency.

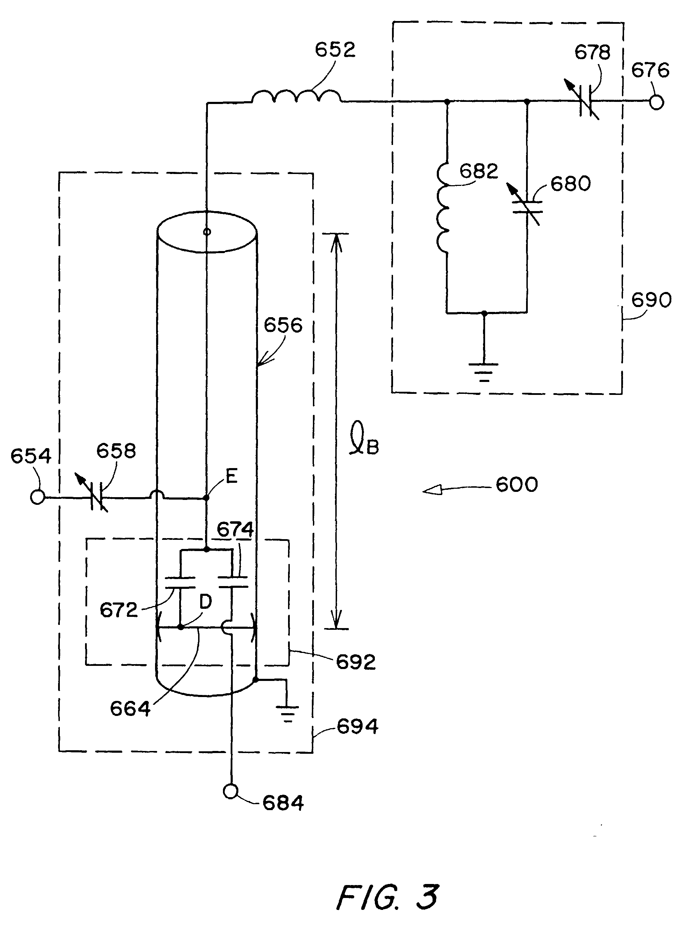

Figure 3 illustrates a second embodiment of the invention. In this second embodiment a single-port tunable element NMR probe 600 is provided for applications requiring three RF frequencies, a high-, a middle-, and a low-frequency. Tunable element 656 is utilized to: tune a high-frequency circuit 694, isolate the low-frequency energy from the high-frequency circuit 694, and remove the matching capacitor 658 from the high voltage region of the probe 600.

A tuning capacitor 672 and a matching capacitor 674 are housed within the tunable element 656. These capacitors are provided to tune the low-frequency portion of the probe. The tuning capacitor 672 functions as a near short circuit at the high-frequency. Therefore, for high frequencies the function of the contact strip 664 of Figure 3 is equivalent to the function of the contact strip 564 in the embodiment represented in Fig. 2. Electrical length ℓ_{B} is selected so that at point D the voltage of the high-frequency is zero and the current is high.

The high-frequency signal is tapped, at point E, into the tunable element 656. This point is chosen to optimize the tuning range of the circuit while removing the matching capacitor from the high voltage region of the probe 600.

The middle-frequency is introduced to the probe 600 at a middle-frequency input terminal 676. A matching capacitor 678 matches the impedance of the middle-frequency circuit 690 to the impedance of the spectrometer channel (not shown) used and the impedance of the preamplifier used (not shown). A tuning capacitor 680 tunes the middle-frequency resonant circuit 690. The tuning capacitor 680 also isolates the high-frequency from the middle-frequency circuit 690 by grounding the high-frequency.

A stop coil 682 forms part of the middle-frequency and low-frequency resonant circuits 690, 692. The stop coil 682 isolates the low frequencies from the middle-frequency resonant circuit 690 by sending the low frequencies to ground. An important consideration in the design of the stop coil 682 is to control the fraction of the available middle-frequency and low-frequency energy that dissipated across the sample coil 652. For example, if the middle-frequency coil 682 is much larger than the sample coil 652, the middle-frequency current follows the sample coil 652 path. As a result, most of the middle-frequency energy is applied to the sample coil 652 and probe 600 performance is optimized for the middle-frequency-but the low-frequency performance will be poor. If the middle-frequency coil 682 is selected to be small in relation to the sample coil 652, the middle-frequency performance will be poor and low-frequency performance will be optimized. It is therefore necessary to find a compromise when selecting the sample coil 652 and middle-frequency coil 682. Coil 652, 682 sizes may be selected to optimize performance for the middle or low-frequency depending on the application.

In this second embodiment, the probe 600 can be designed to operate at many different sets of frequencies. As an example, a high-frequency of 300 Mhz, a middle-frequency of 75 Mhz and a low-frequency of 30 Mhz, may be chosen. Typically, at these frequencies the low-frequency tuning capacitor 672 is selected at 100 to 120 picofarads, and the matching capacitor 674 is selected at 8 picofarads. The tunable element 656 length is 26 centimeters (slightly longer than λ/4 of the high-frequency). The high-frequency matching capacitor 658 value is 0.3- 3.0 pf. The middle-frequency coil 682 is 300 nH and the middle-frequency tuning capacitor 680 is 45pf. The middle-frequency matching capacitor 678 is 4pf. The sample coil is 350nH.

Operation at this set of frequencies has been provided by way of example only. It will be obvious to one of ordinary skill in the art how to build a probe operating at other sets of frequencies.

The electrical length ℓ_{A} in Figure 2 or ℓ_{B} in Figure 3 can be varied using means other than that illustrated in Figures 2-5, such as: positioning a dielectric material inbetween the inner conductor and outer grounded housing; terminate the lower end of the inner conductor with a very small variable reactance (by connecting a variable inductance of value much smaller than the sample coil 652); or any means of altering the characteristic impedance of the tunable elements 556 or 656. Each time a tube-shaped component (not shown) made of a different dielectric material is positioned between the inner and outer grounded housings, the effective electrical length of the tunable element will change. Variable matching capacitors 558, 658 can be replaced with other impedance matching means such as an antenna. For very high frequencies a waveguide having no inner conductor (not shown) may be substituted for tunable elements 556, 656--its effective electrical length can be varied by the same means as set forth above.

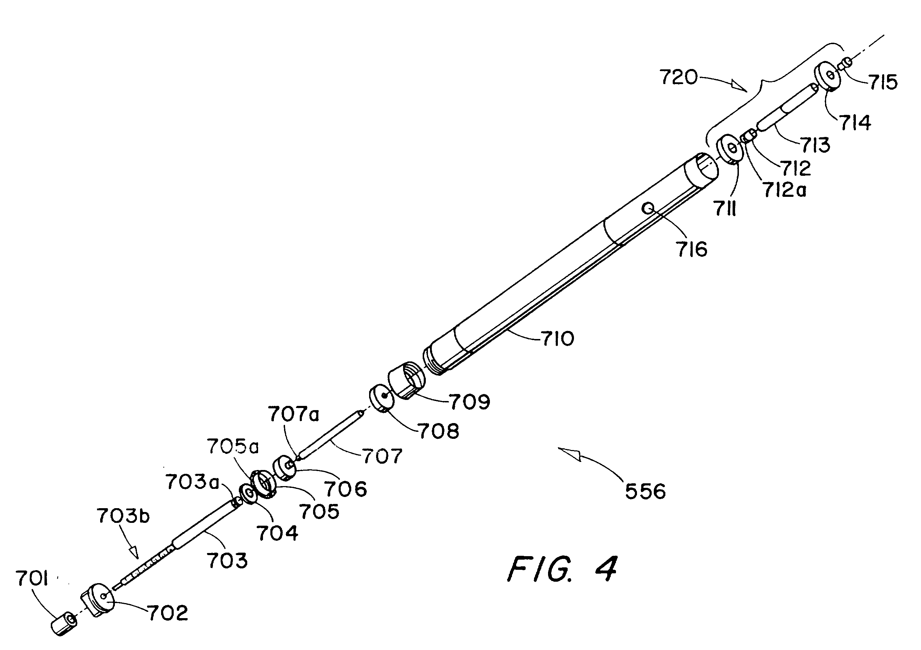

Turning to Figure 4, an inner conductor rod 707 slides up and down within a hollow conductor tube 713 through a guide disk 708. The guide disk 708 guides inner conductor rod 707 into and through contact ring 712. The bottom of inner conductor rod 707 is electrically shorted to a grounded, conductive proton tuning tube 710 via conductive contact fingers 705a of a conductive contact ring 705 which has been secured onto a conductive slider plate 706. As shown, inner conductor rod 707 has a threaded portion 707a which can be screwed into slider plate 706. An RF tap point 716 has been provided through which a high-frequency generator and receiver may be connected via a high-frequency matching capacitor such as that shown at 558, 658 in Figures 2, 3.

The end 703a of slider rod 703 is press-fit, or secured by other means, into slider-plate spacer 704 (which can be made of a nylon such as DELRIN® manufactured by E.I du Pont). Spacer 704 is fit into slider plate 706. A bottom nut 702 screws onto the slider rod 703, which has a threaded portion 703b. Slider rod 703 can be made of any suitable rigid insulative material such as plastic with sufficient mechanical integrity.

The bottom nut 702 is threaded on the outside so that it may be secured into a threaded sleeve 709. The assembly consisting of the inner conductor rod 707, contact ring 705, slider rod 703, slider-plate spacer 704, and slider plate 706 are positioned within the proton tuning tube 710 by screwing threaded sleeve 709 onto the proton tuning tube.

Conductor tube 713 is fitted with a conductive contact ring 712, which has conductive cantilever contact fingers 712a, and two TEFLON® centering spacers 711, 714. The conductor tube assembly, shown at 720, fits inside the proton tuning tube 710. It is necessary that conductor tube 713 be centered within proton tuning tube 710--centering spacers 711, 714 aid in accomplishing this. A conductor tube plug 715 fits onto the top end of the conductor tube 713.

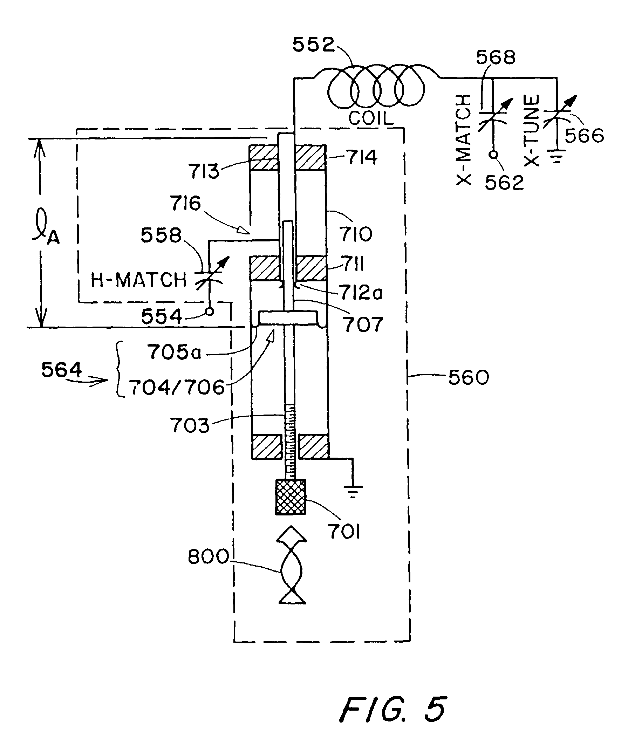

A knob 701, the outside of which has been knurled, is secured onto the end of slider rod 703 so that it may be used to turn slider rod 703. When knob 701 is turned (see, also, the arrow 800 in Figure 5) the threaded slider rod 703 turns within the internal threads of bottom nut 702. This causes the threaded slider rod 703 to move up or down within the proton tuning tube 710 depending upon the direction in which the knob 701 is turned. The movement of slider rod 703 causes inner conductor rod 707 to, correspondingly, slide up or down within conductor tube 713. See, also, Figure 5. As inner conductor 707 slides up into conductor tube 713, the wavelength to which tunable element 556 is tuned is shortened. Similarly, as the inner conductor 707 is retracted from within the conductor tube 713, the wavelength to which tunable element 556 is tuned, lengthens. Note also that contact fingers 705a of contact ring 705, which are electrically connected to inner conductor rod 707, move as inner conductor rod 707 slides within conductor tube 713. Thus, in operation, the tunable element 556 is an adjustable-length waveguide that can be used to tune the high-frequency resonant circuit 560 of NMR probe 500. Mechanical components 705, 705a, 706 may be used to perform the function of the contact strip 564.

There are a number of suitable means for fastening high-frequency matching capacitor 558 to tunable element 556. In the preferred embodiment, high-frequency tuning capacitor 558 is mounted to a brass ring called a deck (not shown) located nearby RF tap point 716. This deck is, in turn, mounted to the proton tuning tube 710.

Although not shown, tunable element 556 of Figure 4 has been modified to house the low-frequency circuit 692 and low-frequency input terminal 684 of the embodiment illustrated in Figure 3. A proton tuning tube 710 for the Figure 3 triple-tuned embodiment has a larger diameter than that necessary for the Figure 2 double-tuned embodiment so that tuning capacitor 672 and matching capacitor 674 may be mounted to or nearby slider plate 706.

While various embodiments of the present invention have been described above, it should be understood that they have been presented by way of example only, and not limitation. Thus, the breadth and scope of the present invention should not be limited by any of the above-described exemplary embodiments, but should be defined only in accordance with the following claims and their equivalents.

## Claims

1. An NMR probe (500;600) for transmitting RF energy between a source and a sample coil (552;652) by means of a tunable element (556;656), the tunable element comprising:
an inner conductor;
a grounded outer conductor;
an electrical path between a first end of the inner conductor and the sample coil (552;652);
a connection between the second end of the inner conductor and the grounded outer conductor; and
means for varying the effective electrical length of the tunable element (556;656); said probe further comprising:
an RF energy terminal (554;654); and
means electrically connected to the inner conductor at a position between the first and the second ends for matching the probe to an impedance value corresponding to an external transmitter/receiver connected, in use, to said RF energy terminal (554;654).

2. A probe as claimed in Claim 1, wherein said means for varying the effective electrical length comprises said inner conductor, having a variable length, electrically connected to said outer grounded conductor via a movable contact strip (564;664).

3. A probe as claimed in Claim 2, further comprising:
a slider rod (703) positioned coaxially within said outer grounded conductor and in contact with said movable contact strip (564;664) and being capable of moving said movable contact strip (564;664) to change said variable length.

4. A probe as claimed in any preceding Claim, wherein said means for varying said electrical length comprises a dielectric material positioned between said inner and outer grounded conductors.

5. A probe as claimed in any preceding Claim, wherein said means for varying said electrical length comprises an electrical component, having a reactance, positioned at said second end.

6. A probe as claimed in any preceding Claim, wherein said means for matching is a variable capacitor (558;658).

7. A probe as claimed in any one of Claims 1 to 6, wherein said means for matching is an antenna having an end inserted into said tunable element (556;656).

8. A probe as claimed in any preceding Claim, wherein said inner conductor comprises:
an inner conductor rod (707) inserted at least partially into a conductor tube (713); and
a conductive first contact ring (712) secured to said conductor tube (713) at an end thereof such that said rod (707) and said tube (713) are in sliding contact.

9. A probe as claimed in Claim 8, further comprising a plug located at said first end.

10. A probe as claimed in Claim 8 or Claim 9, when dependent on Claim 2, wherein said movable contact strip (564;664) comprises a slider plate secured to said inner conductor rod (707), and a second contact ring (705) secured to said slider plate (706).

11. A probe as claimed in any preceding claim, wherein said sample coil (552;652) is capable of transmitting and receiving RF signals at a low-frequency and a high-frequency.

12. A probe as claimed in Claim 11, wherein said sample coil (652) is capable of transmitting and receiving RF signals at a low frequency, a medium frequency, and a high frequency.

13. A probe as claimed in any preceding claim, further comprising:
a second RF resonant circuit (570;690) comprising means for matching said second RF resonant circuit to a second impedance value;
said second RF resonant circuit (570;690) being connected between said sample coil (552;652) and a second RF energy terminal (562;676); and
the first-mentioned RF energy terminal (554;654) being used for inputting said high-frequency RF signal and said second RF energy terminal (562;676) used for inputting said low-frequency RF signal.

14. A probe as claimed in Claim 13, when dependent on Claim 13, further comprising:
a third RF resonant circuit comprising means for impedance matching to a third impedance value and being connected to said inner conductor and a third RF energy terminal (684).

15. A probe as claimed in Claim 15, wherein the first-mentioned RF energy terminal (654) is used for inputting said high-frequency RF signal, said second RF energy terminal (676) is used for inputting said middle-frequency RF signal, and said third RF energy terminal (684) is used for inputting said low-frequency RF signal.

16. A probe as claimed in Claim 15, wherein said first, second and third RF energy terminals (654,676,684) are used for sending RF signals received by said sample coil (652).

17. A method for tuning and matching an RF resonant circuit of an NMR RF probe, comprising the steps of:
transmitting at least one RF signal to a sample coil (552;652) via a tunable element (556;656) comprising an inner conductor and a grounded outer conductor, a first end of the inner conductor being electrically connected to the sample coil (552;652) and the second end being connected to near ground by virtue of an electrical connection between the second end of the inner conductor and the grounded outer conductor;
varying the electrical length of said tunable element (556;656) ; and
matching, at a position between said first and second ends, the RF resonant circuit to a first impedance value.

18. A method as claimed in Claim 17, wherein:
said step of transmitting comprises transmitting said RF signal via an inner conductor of said tunable element (556;656) ; and
said step of varying comprises moving a conductive contact strip (564;664) along an inner wall of an outer grounded conductor surrounding said inner conductor, said contact strip being electrically connected to said inner conductor.

19. A method as claimed in Claim 17, wherein:
said step of transmitting comprises transmitting said RF signal via an inner conductor of said tunable element (556;656) ; and
said step of varying comprises positioning a dielectric material between said inner conductor and an outer grounded conductor surrounding said inner conductor.

## Patentansprüche

1. NMR-Sonde (500; 600) zur Übertragung hochfrequenter Energie zwischen einer Quelle und einer Abtastspule (552; 652) mittels eines abstimmbaren Elementes (556; 656), wobei das abstimmbare Element umfaßt:
einen inneren Leiter;
einen mit Masse verbundenen oder geerdeten äußerer Leiter;
einen elektrischen Pfad zwischen einem ersten Ende des inneren Leiters und der Abtastspule (552; 652);
eine Verbindung zwischen dem zweiten Ende des inneren Leiters und dem geerdeten äußeren Leiter; und
eine Einrichtung zum Verändern der effektiven elektrischen Länge des abstimmbaren Elementes (556; 656);
wobei die Sonde ferner umfaßt:
einen Anschluß (554; 654) für hochfrequente Energie; und
eine Einrichtung, welche mit dem inneren Leiter an einer Stelle zwischen dem ersten und dem zweiten Ende verbunden ist, um die Sonde an einen Impedanzwert anzupassen, der einer im Betrieb an die Anschlußklemme (554; 654) für hochfrequente Energie angeschlossenen externen Sende-/Empfangseinrichtung entspricht.

2. Sonde nach Anspruch 1, bei welcher
die Einrichtung zum Verändern der effektiven elektrischen Länge den inneren Leiter mit variabler Länge umfaßt, der elektrisch mit dem äußeren geerdeten Leiter über einen bewegbaren Kontaktstreifen (564; 664) verbunden ist.

3. Sonde nach Anspruch 2, bei welcher
eine Schiebestange (703) koaxial in dem äußeren geerdeten Leiter angeordnet ist und in Kontakt steht mit dem Kontaktstreifen (564; 664) und welche in der Lage ist, den bewegbaren Kontaktstreifen (564; 664) zu verschieben, um die veränderbare Länge zu ändern.

4. Sonde nach einem der vorstehenden Ansprüche,
bei welcher die Einrichtung zum Verändern der elektrischen Länge ein dielektrisches Material umfaßt, das zwischen dem inneren und dem äußeren geerdeten Leiter angeordnet ist.

5. Sonde nach einem der vorstehenden Ansprüche,
bei welcher die Einrichtung zum Verändern der elektrischen Länge eine elektrische Komponente mit einer Reaktanz umfaßt, die an dem zweiten Ende angeordnet ist.

6. Sonde nach einem der vorstehenden Ansprüche,
bei welcher die Einrichtung zum Anpassen ein variabler Kondensator (558; 658) ist.

7. Sonde nach einem der Ansprüche 1 bis 6, bei welcher
die Einrichtung zum Anpassen eine Antenne mit einem in das abstimmbare Element (556; 656) eingesetzten Ende ist.

8. Sonde nach einem der vorstehenden Ansprüche,
bei welcher der innere Leiter folgendes umfaßt:
eine innere Leiterstange (707), die wenigstens teilweise in eine Leiterröhre (713) eingesetzt ist; und
einen ersten leitfähigen Kontaktring (712), der an der Leiterröhre (713) an dessen einem Ende so gesichert wird, daß sich die Stange (707) und die Röhre (713) in einem gleitenden Kontakt befinden.

9. Sonde nach Anspruch 8, die ferner
einen an dem ersten Ende angeordneten Stecker umfaßt.

10. Sonde nach Anspruch 8 oder 9 in Abhängigkeit von Anspruch 2, bei welcher
der bewegbare Kontaktstreifen (564; 664) eine Schiebeplatte umfaßt, die an der inneren Leiterstange (707) gehalten ist, und wobei ein zweiter Kontaktring (705) an der Schiebeplatte (706) gehalten ist.

11. Sonde nach einem der vorstehenden Ansprüche,
bei welcher die Abtastspule (552; 652) Hochfrequenzsignale bei einer Niederfrequenz und einer Hochfrequenz senden und empfangen kann.

12. Sonde nach Anspruch 11, bei welcher
die Abtastspule (652) Hochfrequenzsignale bei einer niedrigen Frequenz, einer mittleren Frequenz und einer hohen Frequenz senden und empfangen kann.

13. Sonde nach einem der vorstehenden Ansprüche,
ferner umfassend
einen zweiten Hochfrequenz-Resonanzschaltkreis (570; 690), der eine Einrichtung zum Anpassen des zweiten Hochfrequenzschaltkreises an einen zweiten Impedanzwert umfaßt;
wobei der zweite Hochfrequenz-Resonanzschaltkreis (570; 690) zwischen der Abtastspule (552; 652) und einem zweiten Anschluß (562; 676) für hochfrequente Energie angeschlossen ist; und
wobei der zuerst erwähnte Anschluß (554; 654) für hochfrequente Energie zum Einspeisen des hochfrequenten HF-Signals benutzt wird, und der zweite Anschluß (562; 676) für hochfrequente Energie für das Einspeisen des niederfrequenten HF-Signals verwendet wird.

14. Sonde nach Anspruch 13 in Abhängigkeit von Anspruch 12, ferner umfassend
einen dritten Hochfrequenz-Resonanzschaltkreis, der eine Einrichtung zur Impedanzanpassung an einen dritten Impedanzwert umfaßt und mit dem inneren Leiter und einem dritten Anschluß (684) für hochfrequente Energie verbunden ist.

15. Sonde nach Anspruch 14, bei welcher
der zuerst erwähnte Anschluß (654) für hochfrequente Energie für das Einspeisen des HF-Signals mit hoher Frequenz verwendet wird,
der zweite Anschluß (676) für hochfrequente Energie für das Einspeisen des HF-Signals mit mittlerer Frequenz verwendet wird und
der dritte Anschluß (684) für hochfrequente Energie zum Einspeisen des HF-Signals mit niedrigerer Frequenz verwendet wird.

16. Sonde nach Anspruch 15, bei welcher
die erste, zweite und dritte Anschlußklemme (654, 676, 684) für hochfrequente Energie zum Senden von HF-Signalen verwendet werden, die von der Abtastspule (652) empfangen wurden.

17. Verfahren zum Abstimmen und Anpassen eines Hochfrequenz-Resonanzschaltkreises einer Hochfrequenz-Sonde für magnetische Kernresonanz, mit folgenden Schritten:
wenigstens ein HF-Signal wird zu einer Abtastspule (552; 652) über ein abstimmbares Element (556; 656), welches einen inneren Leiter und einen geerdeten äußeren Leiter umfaßt, gesendet, wobei ein erstes Ende des inneren Leiters mit der Abtastspule (552; 652) elektrisch verbunden ist und das zweite Ende mit der nahen Erde durch eine elektrische Verbindung zwischen dem zweiten Ende des inneren Leiters und dem geerdeten äußeren Leiter verbunden ist;
die elektrische Länge des abstimmbaren Elementes (556; 656) wird verändert; und
der Hochfrequenz-Resonanzkreis wird bei einer Stellung zwischen dem ersten und zweiten Ende auf einen ersten Impedanzwert angepaßt.

18. Verfahren nach Anspruch 17, bei welchem
der Sendeschritt das Senden des HF-Signals über einen inneren Leiter des abstimmbaren Elementes (556; 656) umfaßt; und
der Schritt des Änderns das Schieben eines elektrisch leitfähigen Kontaktstreifens (564; 664) entlang einer inneren Wand eines äußeren geerdeten Leiters, der den inneren Leiter umschließt, umfaßt, wobei der Kontaktstreifen elektrisch leitend mit dem inneren Leiter verbunden ist.

19. Verfahren nach Anspruch 17, bei welchem
der Sendeschritt das Senden des HF-Signals über einen inneren Leiter des abstimmbaren Elementes (556; 656) umfaßt; und
der Schritt des Änderns das Anordnen eines dielektrischen Materials zwischen dem inneren Leiter und dem äußeren geerdeten Leiter, welcher den inneren Leiter umschließt, umfaßt.

## Revendications

1. Sonde RMN (500 ; 600) pour transmettre de l'énergie RF entre une source et une bobine échantillon (552 ;652) au moyen d'un élément accordable (556 ; 656), l'élément accordable comprenant :
un conducteur intérieur ;
un conducteur extérieur mis à la terre ;
une ligne électrique entre une première extrémité du conducteur intérieur et la bobine échantillon (552 ; 652) ;
une connexion entre la seconde extrémité du conducteur intérieur et le conducteur extérieur mis à la terre ; et
un moyen afin de faire varier la longueur électrique effective de l'élément accordable (556 ; 656) ; ladite sonde comprenant en outre :
un raccord terminal d'énergie RF (554 ; 654) ; et
un moyen branché électriquement au conducteur intérieur au niveau d'une position entre la première et la seconde extrémité afin d'adapter la sonde à une valeur d'impédance correspondant à un transmetteur / récepteur externe branché, lors de l'utilisation, au dit raccord terminal d'énergie RF (554 ; 654).

2. Sonde telle que revendiquée dans la revendication 1, pour laquelle ledit moyen pour faire varier la longueur électrique effective comprend ledit conducteur intérieur, ayant une longueur variable, connecté électriquement au dit conducteur extérieur mis à la terre par l'intermédiaire d'une bande de contact mobile (564 ; 664).

3. Sonde telle que revendiquée dans la revendication 2, comprenant en outre :
une tige coulissante (703) positionnée de façon coaxiale à l'intérieur dudit conducteur extérieur mis à la terre et en contact avec ladite bande de contact (564 ; 664) mobile et étant capable de mettre en mouvement ladite bande de contact (564 ; 664) mobile afin de changer ladite longueur variable.

4. Sonde telle que revendiquée dans l'une des revendications précédentes, pour laquelle ledit moyen pour faire varier ladite longueur électrique comprend un matériau diélectrique positionné entre lesdits conducteurs intérieur et extérieur mis à la terre.

5. Sonde telle que revendiquée dans l'une des revendications précédentes, pour laquelle ledit moyen pour faire varier ladite longueur électrique comprend un composant électrique, ayant une réactance, positionnée à ladite seconde extrémité.

6. Sonde telle que revendiquée dans l'une des revendications précédentes, pour laquelle ledit moyen pour l'adaptation est une capacité variable (558 ; 658).

7. Sonde telle que revendiquée dans l'une des revendications 1 à 6, pour laquelle ledit moyen pour l'adaptation est une antenne ayant une extrémité insérée dans ledit élément accordable (556 ; 656).

8. Sonde telle que revendiquée dans l'une des revendications précédentes, pour laquelle ledit conducteur intérieur comprend :
une tige conductrice intérieure (707) insérée au moins partiellement dans un tube conducteur (713); et
un premier anneau de contact conducteur (712) fixé au dit tube conducteur (713) à une extrémité dudit tube de telle sorte que ladite tige (707) et ledit tube (713) soient en contact coulissant.

9. Sonde telle que revendiquée dans la revendication 8, comprenant en outre une fiche située à ladite première extrémité.

10. Sonde telle que revendiquée dans la revendication 8 ou la revendication 9, lorsqu'elle relève de la revendication 2, pour laquelle ladite bande de contact mobile (564;664) comprend une plaque coulissante fixée à ladite tige conductrice intérieure (707) et un second anneau de contact (705) fixé à ladite plaque coulissante (706).

11. Sonde telle que revendiquée dans l'une des revendications précédentes, pour laquelle ladite bobine échantillon (552 ; 652) est capable de transmettre et de recevoir des signaux RF à basse fréquence et à haute fréquence.

12. Sonde telle que revendiquée dans la revendication 11, pour laquelle ladite bobine échantillon (652) est capable de transmettre et de recevoir des signaux RF à basse fréquence, à moyenne fréquence et à haute fréquence.

13. Sonde telle que revendiquée dans l'une des revendications précédentes, comprenant en outre :
un second circuit résonnant RF (570 ; 690) comprenant un moyen afin d'adapter ledit second circuit résonnant RF à une seconde valeur d'impédance;
ledit second circuit résonnant RF (570 ; 690) étant connecté entre ladite bobine échantillon (552 ; 652) et un second raccord terminal d'énergie RF (562 ; 676) ; et
le premier raccord terminal d'énergie RF (554 ; 654) mentionné étant utilisé pour entrer ledit signal RF haute fréquence et ledit second raccord terminal d'énergie RF (562 ; 676) étant utilisé pour entrer ledit signal RF à basse fréquence.

14. Sonde telle que revendiquée dans la revendication 13, lorsque qu'elle relève de la revendication 12, comprenant en outre :
un troisième circuit résonnant RF comprenant un moyen pour l'adaptation de l'impédance à une troisième valeur d'impédance et connecté au dit conducteur intérieur et à un troisième raccord terminal d'énergie RF (684).

15. Sonde telle que revendiquée dans la revendication 14, pour laquelle le premier raccord terminal d'énergie RF (654) mentionné est utilisé pour entrer ledit signal RF à haute fréquence, ledit second raccord terminal d'énergie RF (676) est utilisé pour entrer ledit signal RF à moyenne fréquence, et ledit troisième raccord terminal d'énergie RF (684) est utilisé pour entrer ledit signal RF à basse fréquence.

16. Sonde telle que revendiquée dans la revendication 15, pour laquelle lesdits premier, second et troisième raccords terminaux d'énergie RF (654, 676, 684) sont utilisés pour envoyer des signaux RF reçus par l'intermédiaire de ladite bobine échantillon (652).

17. Procédé d'accordage et d'adaptation d'un circuit résonnant RF d'une sonde RF RMN, comprenant les étapes :
de transmettre au moins un signal RF à une bobine échantillon (552 ; 652) par l'intermédiaire d'un élément accordable (556 ; 656) comprenant un conducteur intérieur et un conducteur extérieur mis à la terre, une première extrémité du conducteur intérieur étant connectée électriquement à la bobine échantillon (552 ; 652) et la seconde extrémité étant connectée à la terre proche en vertu d'une connexion électrique entre la seconde extrémité du conducteur intérieur et le conducteur extérieur mis à la terre ;
de faire varier la longueur électrique dudit élément accordable (556 ; 656) ; et
d'adapter, au niveau d'une position entre lesdites première et seconde extrémités, le circuit résonnant RF à une première valeur d'impédance.

18. Une méthode telle que revendiquée dans la revendication 17, pour laquelle :
ladite étape de transmission comprend la transmission dudit signal RF par l'intermédiaire d'un conducteur intérieur dudit élément accordable (556 ; 656) ; et
ladite étape de variation comprend le mouvement d'une bande de contact conductrice (564 ; 664) le long d'une paroi intérieure d'un conducteur extérieur mis à la terre entourant ledit conducteur intérieur, ladite bande de contact étant connectée électriquement au dit conducteur intérieur.

19. Méthode telle que revendiquée dans la revendication 17, pour laquelle :
ladite étape de transmission comprend la transmission dudit signal RF par l'intermédiaire d'un conducteur intérieur dudit élément accordable (556 ; 656) ; et
ladite étape de variation comprend le positionnement d'un matériau diélectrique entre ledit conducteur intérieur et un conducteur extérieur mis à la terre entourant ledit conducteur intérieur.
